**Europäisches Patentamt**

**European Patent Office**

**Office européen des brevets**

(19)

(11) Veröffentlichungsnummer : **0 114 802 B2**

# (12) NEUE EUROPÄISCHE PATENTSCHRIFT

(45) Veröffentlichungstag der neuen Patentschrift :
30.09.92 Patentblatt 92/40

(51) Int. Cl.⁵ : **B32B 7/02, B32B 27/18**

(21) Anmeldenummer : **84890018.9**

(22) Anmeldetag : **23.01.84**

(54) **Mehrschichtiges Verpackungsmaterial mit einer elektrisch leitfähigen Schicht sowie Verfahren zur Herstellung derselben.**

(30) Priorität : **27.01.83 AT 265/83**

(43) Veröffentlichungstag der Anmeldung :
**01.08.84 Patentblatt 84/31**

(45) Bekanntmachung des Hinweises auf die
Patenterteilung :
**08.02.89 Patentblatt 89/06**

(45) Bekanntmachung des Hinweises auf die
Entscheidung über den Einspruch :
**30.09.92 Patentblatt 92/40**

(84) Benannte Vertragsstaaten :
**BE CH DE FR GB IT LI LU NL SE**

(56) Entgegenhaltungen :
EP-A- 0 057 604
DE-A- 3 020 605
FR-A- 2 507 538
US-A- 4 249 226

(56) Entgegenhaltungen :
Prospekt Elpeflex PE Luftpolsterfolie, Firma
AOE Plastic GmbH, Dezember 1980, und Muster Elpeflex 3M
Gächter/Müller, Taschenbuch der Kunst-
stoff-Additive, 2. Auflage, 1983, Carl Hanser
Verlag, S. 590-591, 599-600

(73) Patentinhaber : **Lenzing Aktiengesellschaft**
**A-4860 Lenzing (AT)**

(72) Erfinder : **Zenker, Edmund, Dr. Dipl.-Ing.**
**Schwarzstrasse 7**
**A-4840 Vöcklabruck (AT)**
Erfinder : **Weinrotter, Klaus, Dr. Dipl.-Ing.**
**Edisonstrasse 3**
**A-4840 Vöcklabruck (AT)**
Erfinder : **Neudorfer, Alois**
**Dr. Hamburgerstrasse 9/11**
**A-4840 Vöcklabruck (AT)**
Erfinder : **Gaibinger, Josef**
**Europahof 6**
**A-4840 Vöcklabruck (AT)**

(74) Vertreter : **Wolfram, Gustav, Dipl.-Ing.**
**Patentanwälte Sonn, Pawloy, Weinzinger &**
**Wolfram, Riemergasse 14**
**A-1010 Wien (AT)**

EP 0 114 802 B2

**EP 0 114 802 B2**

**Beschreibung**

Die Erfindung betrifft ein mehrschichtiges Verpackungsmaterial mit einem flexiblen, bahnförmigen Trägermaterial und wenigstens einer mit dem Trägermaterial verbundenen aussenliegenden elektrisch leitfähigen Schicht, bestehend aus einer Suspension von elektrisch leitenden Kohlenstoffteilchen in einer Kunststoffmatrix, sowie ein Verfahren zur Herstellung eines solchen Verpakkungsmaterials.

Die meisten Kunststoffe laden sich infolge ihrer geringen elektrischen Leitfähigkeit in unerwünschter Weise elektrostatisch auf. Bei Überschreiten einer bestimmten Feldstärke des aufgebauten elektrischen Feldes erfolgen Entladungen mit zunehmender Energie als stille Entladung, Büschelentladung oder Gleitstielbüschelentladung. Die Energie eines Funkens, der den Raum zwischen zwei aufgeladenen Körpern überbrückt, ist durch die Beziehung $CU^2/2$ ($C$ = Kapazität, $U$ = Spannung) gegeben. In Anwesenheit von entzündbaren Gas- oder Pulvergemischen führt ein solcher Funken leicht zu Bränden oder Explosionen. Grundsätzlich wird bei Kontakt zweier Festkörper deren Grenzfläche von Ladungsträgern überschritten, bis ein thermodynamisches Gleichgewicht erreicht ist. Die übergegangenen Ladungen treten nach Trennung der beiden Körper dann als elektrostatische Aufladung in Erscheinung, wenn wenigstens einer geringe Leitfähigkeit aufweist.

Der Mechanismus des Ladungsüberganges ist, im Gegensatz zu Übergängen zwischen Metallen oder Halbleitern weitgehend ungeklärt, jedoch sind dafür sowohl Elektronenübergänge, thermische, ionische und piezoelektrische Effekte sowie Influenzerscheinungen als auch die Erzeugung neuer Oberflächen im Zusammenhang mit Zerkleinerungen, Reibungs- oder Bruchvorgängen u.ä. massgeblich.

Empirische Regeln von Coehn besagen, dass der Körper aus dem Stoff mit der grösseren Dielektrizitätskonstante sich positiv auflädt und die Aufladungshöhe proportional der Differenz der Dielektrizitätskonstanten ist. Beim Vergleich mit triboelektrischen Reihen für eine Vielzahl von Kunststoffen bestätigt sich diese Regel allerdings nicht; sie lässt sich auch nicht quantifizieren.

Zur Beurteilung des Aufladungsverhaltens von Werkstoffen wird deren Oberflächenwiderstand und deren Durchgangswiderstand, bestimmt nach DIN 53 482, DIN 53 486 und DIN 54 345 herangezogen. Die Aufladungshöhe und die Halbwertzeit der Entladung (als Mass für den Ladungsfluss) nehmen mit dem Oberflächenwiderstand ab. in sicherheitstechnischer Hinsicht gilt ein Werkstoff als nicht mehr aufladbar, wenn sein Oberflächenwiderstand beim Klima 23°C, 50% rel. Feuchte kleiner als $10^9\Omega$ ist oder unter extremen Bedingungen $10^{11}\Omega$ nicht überschreitet (Definition gemäss Richtlinie Nr.4 der Berufsgenossenschaft der chemischen Industrie, Verlag Chemie, Weinheim 1967).

Es gibt zwar keine allgemein anerkannte Definition der Begriffe antistatisch, aufladbar bzw. elektrostatisch leitfähig, man kann aber eine Einstellung in drei Werkstofftypen vornehmen, wofür sich folgende Benennungen als zweckmässig erwiesen haben:

1. hochaufladbare Stoffe: Oberflächenwiderstand grösser $10^{14}\Omega$. z.B. Polyolefine, Poycarbonate (PC), Polyvinylchlorid (PVC), Polymethylmethacrylat (PMMA)
2. astatische Werkstoffe: Oberflächenwiderstand $10^9$-$10^{14}\Omega$, z.B. Polyamide (PA), Acrylnitril-Butadien-Styrol-(ABS-)-Copolymere, Celluloseabkömmlinge, Thermoplaste mit antistatischen Ausrüstungen.
3. antistatische Werkstoffe: das sind solche, die entsprechend der sicherheitstechnischen Grenze (Oberflächenwiderstand kleiner $10^9\Omega$) als nicht mehr aufladbar gelten.

Bisher wurde eine Vielzahl von Versuchen unternommen, Werkstoffe im allgemeinen und Kunststoffe im besonderen antistatisch auszurüsten, wobei grundsätzlich nach zwei Alternativen vorgegangen wurde:

Innere Ausrüstung durch Inkorporation leitfähigkeitserhöhender Substanzen wie z.B. Russ, Graphit, Metallpulver, -fäden oder -plättchen. Äussere Ausrüstung druch eine Oberflächenbehandlung, nämlich:

– Aufdampfen von Metallschichten,

– Aufdrucken von Russ- oder Graphitpasten oder anderer leitfähigkeitserhöhender Substanzen, beispielsweise von Metaloxiden oder Salzen,

– Imprägnieren poröser Trägermaterialien, z. B. Vliese, Gewebe, Schaumstoffe, mit Graphitstaub-Dispersionen und anschliessender Trocknung.

Zur Erzielung homogener, niedriger Widerstandswerte bei Werkstoffen mit innerer Ausrüstung ist gegenseitige Berührung der leitfähigen Additivteilchen notwendig, weswegen die leitfähigkeitserhöhenden Füllstoffe in relativ hohen Konzentrationen in das Matrix-Material eingebettet werden müssen, wodurch aber in den meisten Fällen die mechanischen Eigenschatten des Matrix-Materials deutlich verschlechtert werden.

Äussere Ausrüstungen sind insbesondere bei Kunststoffen nicht generell anwendbar bzw. sie bringen erhebliche Nachteile mit sich.

Verbundmaterialien mit wenigstens einer Metallschicht sind bekannt; so wird beispielsweise Aufdampfen von Metallschichten auf Polyesterfolien oder -geweben in grossem Umfang durchgeführt. Das Bedampfen von beispielsweise Polyolefinfolien oder -geweben ist jedoch wegen zu geringer Haftung zwischen Trägermaterial und aufgedampfter Metallschicht nicht praktizierbar.

2

Eine Einschränkung hinsichtlich der Verwendbarkeit solcher « metallisierter » Trägermaterialien besteht darin, dass z.B. metallbedampfte Folien thermisch nicht mehr verschweissbar sind und somit die Herstellung beidseitig leitfähiger Verpackungen nicht möglich ist.

Imprägnierte oder bedruckte Trägermaterialien unterliegen bei ihrem Einsatz in vielen Fällen hohem Abrieb, was z.B. bei Anwendungen in der Electronik dazu führen kann, dass leitfähige, abgeriebene Partikel (vorwiegen Graphit) eng beieinanderliegende Leiterbahnen auf Printplatten kurzschliessen können.

Ein mehrschichtiges Material der eingangs genannten Art ist aus der US-A-4 249 226 bekannt.

Die vorliegende Erfindung stellt sich die Aufgabe, durch die Kombination bestimmter Matrixmaterialen der leitfähigen Schicht mit einem bestimmten Tragermaterial universell einsetzbare Verpackungsmaterialien mit einem weiten Sprektrum von mechanischen Eigenschaften, welche Materialien über einen praktisch unbegrenzten Zeitraum nicht elektrostatisch aufladbar sind, zu schaffen. Ferner betrifft die Erfindung ein Verfahren, das die Schwierigkeiten bei der Herstellung der bekannten Materialien überwindet.

Die gestellte Aufgabe wird bei einem mehrschichtigen Verpackungsmaterial erfindungsgemäss dadurch gelöst,

– daß das Trägermaterial aus einem offenmaschigen Gewebe besteht,

– daß die Matrix der elektrisch leitfähigen Schichten in an sich bekannnter Weise aus Homo- oder Copolymerisaten von Polyolefinen, aus Polyamid-(PA)-oder aus Polyurethan-(PU)-Elastomeren besteht,

– daß der Durchgangswiderstand der elektrisch leitfähigen Schichten im Bereich von $10^3$ bis $10^8$ $\Omega.cm$ liegt, und

– daß der Oberflächenwiderstand der elektrisch leitfähigen Schichten im Bereich von $10^2$ bis $10^8$ $\Omega$ liegt.

In dem erfindungsgemässen Verpackungsmaterial sind die Eigenschaften der leitfähigen Kunststoffschicht mit den Eigenschaften des flexiblen Trägermaterials kombiniert. Da die elektrisch leitfähige Schicht genügend Flexibilität aufweist, können sich beispielsweise auch bei geringer Schichstärke keine Risse ausbilden, wie sie in Metallschichten auftreten können.

Aufgrund seines niedrigen Oberflächenwiderstandes ist des erfindungsgemässe Verpackungsmaterial einerseits nicht elektrostatish aufladbar und kann anderseits bei Kontakt mit elektrostatisch aufgeladenen Gegenständen oder Personen deren Ladungen ohne Funkenbildung ableiten.

Werden zwei Schichten aus leitfähigem Kunststoff vorgesehen, so stehen sie an bestimmten kleinen Flächenbereichen miteinander in Verbindung, und das Verpackungsmaterial weist nicht nur einen geringen oberflächenwiderstand, sondern auch über seinen gesamten Querschnitt - abhängig von der Zusammensetzung und der Stärke der leitfähigen Schicht - einen relativ niedrigen Durchgangswiderstand auf.

Die Kohlenstoffteilchen können aus Graphit bestehen, weiters kommen leitfähige Russe, vor allem Ofen- und Acetylenrusse, aber auch die weniger gut elektrisch leitenden Thermal- und Kanalrusse in entsprechend höheren Zusatzmengen in Frage. Leitfähige Russe weisen aufgrund ihrer Struktur eine durch Stickstoff-Adsorption gemessene Oberfläche von etwa 200 bis 1000 $m^2g$ auf, bei Russen vom graphitischen Typ liegen diese Oberflächen im Bereich von 1 bis 10 $M^2/g$ . Einzelheiten über die Bestimmung und Charakterisierung der Russtypen sind in « Encyclopedia of industrial Chemical Analysis » 1969, Band 8, Seite 179, John Wiley & Sons, New York, angegeben.

Vorzugsweise werden als Homo- oder Copolymerisate von Polyolefinen Polyäthylen niedriger Dichte (LDPE), lineares Polyäthylen niedriger Dichte (L-LDPE), Polypropylen (PP), Äthylen-Vinylacetat-Copolymerisate (EVA), Äthylen-Äthylacrylat-Copolymerisate (EAA), Äthylen-Butylacetat-Copolymerisate (EBA) oder Mischungen davon verwendet.

Zweckmässig enthält die elektrisch leitfähige Kunststoffschicht 5 bis 35% Masse an leitfähigem Russ.

Besonders bevorzugt ist die elektrisch leitfähige Kunststoffschicht überdies thermisch verschweissbar (auf einfache Weise können Heisssiegelnähte angebracht werden).

Die Stärke der Schicht aus leitfähigem Kunststoff liegt im allgemeinen zwischen 20 und 500 $\mu m$, vorzugsweise zwischen 100 und 300 $\mu m$.

Das erfindungsgemässe Verfahren zur Herstellung des beschriebenen Verpeckungs-materials durch Beschichten eines flexiblen, bahnförmigen Trägermaterials mit einem Kunststoff, welcher elektrisch leitende Kohlenstoffteilchen suspendiert enthält, ist dadurch gekennzeichnet, daß ein offenmaschiges Gewebe mit einer Suspension von leitfähigem Russ und/oder Graphit in Homo- oder Copolymerisaten von Polyolefinen, in Polyamid-(PA)- oder in Polyurethan-(PU)-Elastomeren durch Breitschlitzdüsenextrusion ein- oder beidseitig beschichtet wird.

Der russhältige leitfähige Kunststoff wird bei der Breitschlitzdüsenextrusion in einem Kalandrierspalt auf das Trägermaterial aufgebracht, wodurch vollflächige Verbindung der Schichten erfolgt.

**Patentansprüche**

1. Mehrschichtiges Verpackungsmaterial mit einem flexiblen, bahnförmigen Trägermaterial und wenigstens einer mit dem Trägermaterial verbundenen außenliegenden elektrisch leitfähigen Schicht, bestehend aus einer Suspension von elektrisch.leitenden Kohlenstoffteilchen in einer Kunststoffmatrix, gekennzeichnet durch die Kombination der Merkmale:
   – daß das Trägermaterial aus einem offenmaschigen Gewebe besteht,
   – daß die Matrix der elektrisch leitfähigen Schichten in an sich bekannnter Weise aus Homo- oder Copolymerisaten von Polyolefinen, aus Polyamid-(PA)-oder aus Polyurethan-(PU)-Elastomeren besteht,
   – daß der Durchgangswiderstand der elektrisch leitfähigen Schichten im Bereich von $10^3$ bis $10^8$ $\Omega$.cm liegt, und
   – daß der Oberflächenwiderstand der elektrisch leitfähigen Schichten im Bereich von $10^2$ bis $10^8$ $\Omega$ liegt.

2. Verpackungsmaterial nach Anspruch 1, dadurch gekennzeichnet, dass als Homo- oder Copolymerisate von Polyolefinen Polyäthylen niedriger Dichte (LDPE), lineares Polyäthylen niedriger Dichte (L-LDPE), Polypropylen (PP), Äthylen-Vinylacetat-Copolymerisate (EVA), Äthylen-Äthylacrylat-Copolymerisate (EAA), Äthylen-Butylacetat-Copolymerisate (EBA) oder Mischungen davon verwendet werden.

3. Verpackungsmaterial nach einem oder beiden der Ansprüche 1 und 2, dadurch gekennzeichnet, dass die elektrisch leitfähige Schicht 5 bis 35% Masse an leitfähigem Russ enthält.

4. Verpackungsmaterial nach einem oder mehreren der Ansprüche 1 bis 3, dadurch gekennzeichnet, dass die leitfähige Schicht thermisch verschweissbar ist.

5. Verfahren zur Herstellung eines Verpakkungsmaterials nach einem oder mehreren der Ansprüche 1 bis 4 durch Beschichten eines flexiblen, bahnförmigen Trägermaterials mit einem Kunststoff, welcher elektrisch leitende Kohlenstoffteilchen suspendiert enthält, dadurch gekennzeichnet, dass ein offenmaschiges Gewebe mit einer Suspension von leitfähigem Russ und/oder Graphit in Homo- oder Copolymerisaten von Polyolefinen, in Polyamid-(PA)- oder in Polyurethan-(PU)-Elastomeren durch Breitschlitzdüsenestrusion ein- beidseitig beschichtet wird.


**Claims**

1. Layered packaging material with a flexible web-shaped support material and at least one externally situated electrically conductive layer bound to the support material consisting of a suspension of electrically conductive carbonaceous particles in a matrix of synthetic material, characterized by the combination of the characteristics:
   – the support material consists of an open-loop tissue,
   – the matrix of the elctrically conductive layer consists, in manner known _per se_, of homo- or co-polymerizates of polyolefines, of polyamide-(PA)-elastomers or of polyurethane-(PU) -elastomers,
   – the electrical resistance of the elctrically conductive layer is in the region of $10^3$ to $10^8$ ohm.cm, and
   – the surface resistance of the electrically conductive layer is in the region of $10^2$ to $10^8$ ohm.cm.

2. Packaging material according to Claim 1, characterized in that low density polyethylene (LDPE), low density linear polyethylene (L-LDPE), polypropylene (PP), ethylene-vinylacetate copolymerize (EVA), ethy-lene-ethylacrylate copolymerize (EAA), ethylene-butylacetate copolymerize (EBA) or mixtures of them are employed as the homo- or co-polymerizates of polyolefines.

3. Packaging material according to one or both of Claims 1 and 2, characterized in that the electrically conductive layer contains 5 to 35 % by weight of electrically conductive carbon black.

4. Packaging material according to one or more of Claims 1 to 3, characterized in that the electrically conductive layer can be thermally welded.

5. A process for manufacturing a packaging material according to one or more of Claims 1 to 4 by coating a flexible web-shaped support material with a synthetic material which contains suspended electrically conductive carbonaceous particles, characterized in that an open-loop tissue is coated on one or both sides with a suspension of electrically conductive carbon black and/or graphite in homo- or co-polymerizates of polyolefines, in polyamide-(PA)-elastomers or in polyurethane-(PU) -elastomers by wide-slit jet extrusion.

**Revendications**

1. Matériau d'emballage à plusieurs couches comportant un matériau de support flexible en bande et au moins une couche extérieure conductrice de l'électricité reliée au matériau de support, consistant en une suspension de particules de carbone conductrices de l'électricité dans une matrice de matière plastique, caractérisé par les poids suivants en combinaison :
   – le matériau de support consiste en un tissu à mailles ouvertes,
   – la matrice des couches conductrices de l'électricité consiste de manière connue en homo- ou copolymères de polyoléfines, en élastomères de polyamides (PA) ou en élastomères de polyuréthannes (PU),
   – la résistance intérieure des couches conductrices de l'électricité est située dans le domaine de $10^3$ à $10^8$ Ohm.cm, et
   – la résistance superficielle des couches conductrices de l'électricité est située dans le domaine de $10^2$ à $10^8$ Ohm.cm.

2. Matériau d'emballage selon la revendication 1, caractérisé en ce que l'on utilise comme homo- ou copolymères de polyoléfines le polyéthylène basse densité (LDPE), le polyéthylène basse densité linéaire (L-LDPE), le polypropylène (PP), les copolymères éthylène-acétate de vinyle (EVA), les copolymères éthy-lèneacrylate d'éthyle (EAA), les copolymères éthylène-acétate de butyle (EBA) ou leurs mélanges.

3. Matériau d'emballage selon une au moins des revendications 1 et 2, caractérisé en ce que la couche conductrice de l'électricité contient 5 à 35 % en poids de noir de carbone conducteur.

4. Matériau d'emballage selon une ou plusieurs des revendications 1 à 3, caractérisé en ce que la couche conductrice de l'électricité est soudable à chaud.

5. Procédé pour la fabrication d'un matériau d'emballage selon une ou plusieurs des revendications 1 à 4 par enduction d'un matériau de support flexible en bande avec une matière plastique qui contient en suspension des particules de carbone conductrices de l'électricité, caractérisé en ce que l'on enduit, sur une ou sur les deux faces, un tissu à mailles ouvertes avec une suspension de noir de carbone conducteur et/ou de graphite dans des homo- ou copolymères de polyoléfines, des élastomères de polyamides (PA) ou des élastomères de polyuréthannes (PU) par extrusion à travers une filière plate.